Europäisches Patentamt

European Patent Office

Office européen des brevets

(19)

(11)  EP 1 248 369 A2

(12)  EUROPÄISCHE PATENTANMELDUNG

(43) Veröffentlichungstag:
09.10.2002  Patentblatt 2002/41

(51) Int Cl.⁷: H03K 17/95, G01D 5/14

(21) Anmeldenummer: 02005156.1

(22) Anmeldetag: 08.03.2002

(84) Benannte Vertragsstaaten:
AT BE CH CY DE DK ES FI FR GB GR IE IT LI LU
MC NL PT SE TR
Benannte Erstreckungsstaaten:
AL LT LV MK RO SI

(30) Priorität: 02.04.2001  DE 10116411

(71) Anmelder: ABB Research Ltd.
8050 Zürich (CH)

(72) Erfinder:
• Bloch, Richard
  5415 Nussbaumen (CH)
• Prêtre, Philippe
  5405 Baden-Dättwil (CH)

(74) Vertreter: Miller, Toivo et al
ABB Patent GmbH
Postfach 1140
68520 Ladenburg (DE)

(54)  **Näherungssensor und Verfahren zu seinem Betrieb**

(57)    Eine elektronische Schaltung zu einem Näherungssensor, welcher targetunabhängig ist und auf einer Phasenprojektionstransformation beruht, wird derart ausgelegt, dass der Schwingkreis 3 mit einer Rechteckspannung U 1 angetrieben werden kann. Ein Synchrondemodulator 5 wird zur Phasenprojektionstransformation eingesetzt. Miniaturisierung ist möglich, und
an die Stabilität der Speisespannung U0 sind nur geringe Anforderungen gestellt.

Fig. 1

EP 1 248 369 A2

**Beschreibung**

TECHNISCHES GEBIET

Die vorliegende Erfindung betrifft einen Näherungssensor gemäss dem Oberbegriff des Patentanspruchs 1 sowie ein Verfahren zu seinem Betrieb.

STAND DER TECHNIK

Bekannte Näherungssensoren enthalten einen Schwingkreis mit einem Kondensator und einer Spule, dessen Impedanz sich durch Annähern eines metallischen Auslösers oder Targets ändert. Bei einem induktiven Näherungssensor wird durch den Auslöser die Induktivität der Schwingkreisspule beeinflusst, bei einem kapazitiven Näherungssensor hingegen die Kapazität des Schwingkreiskondensators. Durch die Änderung der Impedanz des Schwingkreises ändert die Amplitude des Schwingkreissignals. Dieses Signal wird gleichgerichtet und im Falle eines Näherungsschalters durch einen Diskriminator in ein die Anoder Abwesenheit des Auslösers anzeigendes Signal gewandelt.

Die Schwingkreisamplitude hängt von der Schwingkreisfrequenz, von der Position des Auslösers, d.h. seinem Abstand zum Sensor, und dem Auslösermaterial ab. Bei unterschiedlichen Auslösern wird der Diskriminator im Allgemeinen bei unterschiedlichen Schaltdistanzen, d.h. bei unterschiedlichem Abstand zwischen Auslöser und Sensor, ansprechen. Deshalb sind handelsübliche Näherungsschalter auslösermaterialspezifisch und es werden Reduktionsfaktoren in der Schaltdistanz definiert. So beträgt bei induktiven Näherungsschaltern die Schaltdistanz für ein Kupfertarget hauptsächlich aufgrund der unterschiedlichen magnetischen Eigenschaften nur 30% der Schaltdistanz von Werkzeugstahl.

In der noch unveröffentlichten Deutschen Patentanmeldung 19947380.3, deren Offenbarung integraler Bestandteil der nachfolgenden Beschreibung ist, wird ein Näherungssensor beschrieben, welcher vom Material eines Auslösers oder Targets unabhängig ist. Dabei wird von einer stationären komplexen Systemgrösse, wie beispielsweise der Impedanz Z des Schwingkreises oder der Amplitude U des Schwingkreissignals, welche von der Position und dem Material des Auslösers abhängt, eine auslösermaterialunabhängige Komponente abgespaltet. Dieser Vorgang entspricht einer Projektion der im Einsatz des Näherungssensors laufend aktualisierten Systemgrösse auf eine durch den schwingkreisfrequenzabhängigen Winkel $\xi$ festgelegte Richtung, woraus anschliessend der Auslöserabstand d bestimmt werden kann. Diese Phasenprojektionstransformation umfasst eine Multiplikation des Schwingkreissignals mit einem um den Winkel $\xi$ phasenverschobenen Referenzsignal, welche vorzugsweise in analoger Form in einem Lock-In Verstärker durchgeführt wird. Die Erzeugung, Stabilisierung und Multiplikation der verwendeten sinusförmigen Signale ist elektronisch betrachtet relativ aufwändig und für eine Miniaturisierung des Sensors nur beschränkt geeignet.

DARSTELLUNG DER ERFINDUNG

Aufgabe der vorliegenden Erfindung ist es, einen auslöserunabhängigen Näherungssensor der eingangs genannten Art derart auszubilden, dass auf sinusförmige Signale verzichtet werden kann. Diese Aufgabe wird durch einen Näherungssensor mit den Merkmalen des Patentanspruchs 1 und ein Verfahren zum Betrieb eines Näherungssensors mit den Merkmalen des Patentanspruchs 6 gelöst.

Kern der Erfindung ist es, bei einem Näherungssensor rechteckförmige Signale, wie sie integrierte Halbleiterbauelemente zu erzeugen vermögen, einzusetzen. Ein Synchrondemodulator, welcher durch ein phasenverschobenes Referenzsignal angesteuert wird, sorgt für die Phasenprojektionstransformation des auszuwertenden Schwingkreissignales. Durch den Einsatz von digitalen Bauelementen wird ein strom- und platzsparender Sensor erreicht.

In einer ersten Ausführungsform des erfindungsgemässen Näherungssensors ist die Schwingkreisfrequenz zumindest annähernd gleich der targetabhängigen Resonanzfrequenz des Schwingkreises.

In einer zweiten Ausführungsform des erfindungsgemässen Näherungssensors wird dieser um einen Komparator ergänzt und als Näherungsschalter eingesetzt. Der Komparator vergleicht ein den Auslöserabstand charakterisierendes Signal mit einem Schwellwert. Schwellwertbilder und Signalgenerator sind beide mit ein und derselben Speisegleichspannung verbunden, wodurch eine Unabhängigkeit von den zeitlichen Schwankungen Letzterer erzielt wird.

Weitere vorteilhafte Ausführungsformen gehen aus den abhängigen Patentansprüchen hervor.

KURZE BESCHREIBUNG DER FIGUREN

Nachfolgend wird die Erfindung anhand von Ausführungsbeispielen im Zusammenhang mit den Zeichnungen näher erläutert. Es zeigen

Fig.1 eine elektronische Schaltung für einen erfindungsgemässen Näherungssensor, und

Fig.2 eine erweiterte Schaltung für einen Einsatz des Näherungssensors als Schalter.

Die in den Zeichnungen verwendeten Bezugszeichen sind in der Bezugszeichenliste zusammengefasst. Grundsätzlich sind gleiche Teile mit denselben Bezugszeichen versehen.

WEGE ZUR AUSFÜHRUNG DER ERFINDUNG

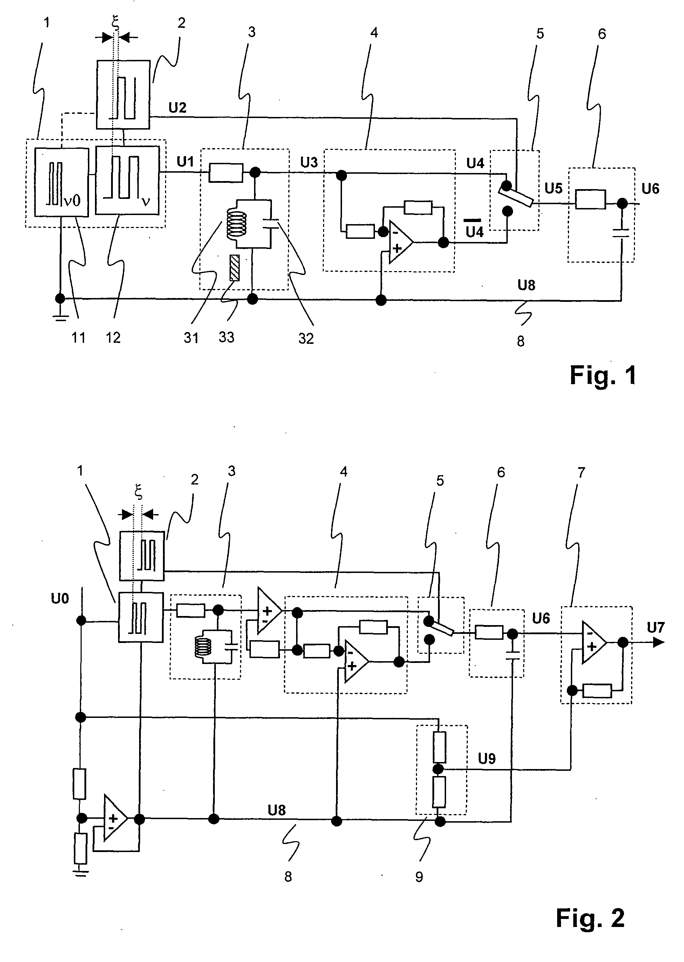

In Fig. 1 ist ein erstes Prinzipschema der Auswerteelektronik eines erfindungsgemässen Näherungsensors dargestellt. Ein Signalgenerator 1 erzeugt ein geeignetes periodisches Signal beziehungsweise eine erste Spannung U1, welche einem Phasenverzögerer 2 und einem Schwingkreis 3 zugeführt wird. Der Phasenverzögerer 2 erzeugt ein Signal U2 mit einer gegenüber U1 um den Winkel $\xi + \pi/2$ verzögerten Phase. Der Schwingkreis 3, das eigentliche Kernstück des Sensors, umfasst eine Spule 31 und eine Kapazität 32, seine Impedanz Z3 wird wesentlich durch die Entfernung eines zu detektierenden Targets oder Auslösers 33 bestimmt. Das ausgangsseitige Schwingkreissignal beziehungsweise die ausgangsseitige Spannung ist mit U3 bezeichnet. Eine nachgeschalteter Inverter 4 erzeugt zusätzlich zu U3 ($\equiv$U4) noch ein dazu invertiertes Signal $\overline{U4}$. Diese beiden Signale werden einem Synchrondemodulator 5 zugeführt. Der Demodulator 5 wird gesteuert durch das phasenverschobene Signal U2 und schaltet wahlweise eines der zwei Signale U4 oder $\overline{U4}$ durch. Das derart erzeugte, demodulierte Signal U5 wird anschliessend durch den Tiefpassfilter 6 gefiltert, die resultierende DC Spannung U6 ist, wie weiter unten gezeigt wird, proportional zur gesuchten targetunabhängigen Komponente des Schwingkreissignals U3.
Erfindungsgemäss ist das vom Signalgenerator 1 erzeugte Signal U1 ein Rechtecksignal und kein sinusförmiges Signal. Es wird vorzugsweise durch einen feldprogrammierbaren Gatterbaustein (field programmable gate array) erzeugt. Der Demodulator 5 ersetzt den Multiplikator der strikten Analoglösung, hat im Wesentlichen die Funktion eines Relais und besteht vorzugsweise aus einem integrierten Analogumschalter, wie sie beispielsweise unter der Bezeichnung Maxim 4544 erhöltlich sind. Wesentlich dabei ist, dass sein Widerstand im durchgeschalteten Ast klein ist gegenüber dem Widerstand des nachfolgenden Tiefpassfilters 6. Signalgenerator 1, Schwingkreis 3, Inverter 4 und Tiefpassfilter 6 sind auf ein gemeinsames Referenzpotential geschaltet über eine Verbindung 8, welche im Falle der Ausführungsform gemäss Fig.1 identisch auf Erde liegt. Die Verwendung von Rechtecksignalen und integrierten digitalen Bauelementen erlaubt eine Miniaturisierung und eine stromsparende Ausführung, welche insbesondere für drahtlose Näherungsschalter mit induktiver Energieeinspeisung geeignet ist.
Die Wirkungsweise des Synchrondemodulators 5 in Verbindung mit dem Inverter 4, d.h. die wahlweise Durchschaltung von U4 oder $\overline{U4}$, entspricht einer Multiplikation des normierten, phasenverschobenen Referenzsignals U2 mit dem am einen Eingang des Demodulators 5 anliegenden Schwingkreissignal U3. Für rechteckförmige Signale gilt die Fourierzerlegung mit ungeradzahligen Vielfachen der Schwingkreisfrequenz $\nu$, so dass

$$U_2 \cdot U_3 \propto \left[\sin\left(2\pi\upsilon t + (\xi + \pi/2)\right) + \ldots\right] \cdot \left[A_1 \sin\left(2\pi\upsilon t + \varphi_1\right) + A_3 \sin\left(6\pi\upsilon t + \varphi_3\right) + \ldots\right],$$

$$\propto A_1\left[\cos\left(\varphi_1 - (\xi + \pi/2)\right) - \cos\left(6\pi\upsilon t + \varphi_1 + (\xi + \pi/2)\right)\right] + \ldots.$$

nach der Tiefpassfilterung bleiben nur Gleichstromterme bestehen, d.h.

$$U_2 \cdot U_3 \propto \sum_{n} \frac{2A_n}{2n-1} \cos\left(\varphi_n - (2n-1)(\xi - \pi/2)\right) \propto \left[A_1 \sin\left(\varphi_1 - \xi\right) + \ldots\right].$$

Allgemein ist also mit $A_1 \gg A_3$ das Signal U6 in ausreichender Näherung gleich der gesuchten Projektion des Schwingkreissignals U3 auf die durch den Winkel $\xi$ bestimmte Richtung. Falls zudem der Schwingkreis 2 bereits ein Filterelement mit Resonanz in der Nähe der Schwingkreisfrequenz $\nu$ bildet, wird die Amplitude $A_1$ der Grundfrequenz $\nu$ erst recht dominieren. Der Schwingkreis filtert dann alle Oberwellen weg, und das Signal U3 ist zumindest näherungsweise eine Sinusfunktion wie im Falle einer analogen Anregung des Schwingkreises. Aus Stabilitätsgründen ist es aber auch in diesem Falle besser, eine Schwingkreisfrequenz $\nu$ zu wählen, welche sich um zumindest etwa 5% von der Resonanzfrequenz unterscheidet.

Vorzugsweise umfasst der Rechtecksignalgenerator 1 ein Mittel 11 zur Erzeugung einer Basisfrequenz ν0, welche anschliessend durch einen Frequenzteiler 12 durch den Faktor N auf den Wert der gewünschten Schwingkreisfrequenz ν geteilt wird. Der Phasenverzögerer 2 umfasst ein Schieberegister mit n Zellen, welches durch die Basisfrequenz ν0 getaktet wird. Bei jedem clock, d.h. 1/ν0 mal pro Sekunde, wird der binäre Inhalt jeder Zelle eine Zelle weitergereicht, so dass sich insgesamt zwischen U2 und U1 ein dem Winkel ξ + π/2 entsprechender Phasenunterschied von n/N 360° erzielen lässt.

Fig.2 zeigt ein erweitertes Prinzipschema der Sensorelektronik, welches für einen Einsatz des Näherungssensors als Näherungsschalter geeignet ist. Bei einem Näherungsschalter wird das Signal U6 weiter einem Komparator oder Diskriminator 7 zugeführt. Dieser wandelt das Signal in Abhängigkeit einer einem bestimmten Schaltabstand zugeordneten Diskriminatorschwelle U9 in ein Signal um, dessen Vorzeichen die Zustände "Auslöser anwesend" und "Auslöser abwesend" repräsentiert. Der in Fig.2 dargestellte Komparator 7 ist weiter mit einer Rückkopplung zwischen einem Verstärkerausgang und einem Verstärkereingang ergänzt. Dies geschieht zur Einführung einer Schaltabstandshysterese, die für einen stabilen Betrieb des Schalters benötigt wird. Falls der Sensor zu Stromsparzwecken getaktet betrieben wird, d.h. nur während typischerweise einem Zehntel der Zeit an einer Versorgungsspannung U0 angeschlossen ist, muss eine Hysteresespannung zusätzlich in einem Speicherbaustein abgelegt werden.

Der Signalgenerator 1 beziehungsweise der gesamte Sensor wird durch eine Speise-Gleichspannung U0 gespiesen. Insbesondere bei den erwähnten drahtlosen Näherungsschaltern ist diese Speisespannung U0 jedoch nicht konstant sondern zeitlichen Schwankungen unterworfen. In der Ausführungsform gemäss Fig.2 liegt die Verbindung 8 nicht auf Erde, sondern auf einem Potential U8, welches einen Wert zwischen Null und der Speisespannung U0, also beispielsweise U0/2, annimmt. Durch die beiden Widerstände eines Schwellwertbilders 9 wird ein Vergleichssignal oder Schwellwert U9 definiert, welches zwischen U8 und U0 liegt und dem Komparator 7 zusammen mit dem im selben Bereich liegenden tiefpassgefilterten Signal U6 zugeführt wird. Bei dieser Ausführungsform werden ähnlich einer Messbrücke Schwankungen in der Speisespannung U0 automatisch proportional bei allen internen Spannungspegeln wie Schwellwert und Signal mitgeführt. Es ergibt sich ein von der Speisespannung U0 unabhängiges Schaltverhalten des Näherungsschalters, so dass keine übertriebenen Ansprüche an deren Stabilität gestellt werden müssen.

Die Basisfrequenz ν0 beträgt beispielsweise 1.8 MHz, und die Schwingkreisfrequenz ν nach der Frequenzteilung durch den Faktor 6 noch 300 kHz, welche bei entsprechend gewählter Schwingkreisinduktivität beziehungsweise -impedanz zumindest annähernd der Resonanzfrequenz des Schwingkreises für einen mittleren Targetabstand entspricht. Bei nur einer Zelle im Schieberegister resultiert eine Phasenverschiebung von 60°. Die Versorgungsspeisegleichspannung $U_0$ beträgt typischerweise 3 V.

BEZUGSZEICHENLISTE

1 Signalgenerator
11 Basisfrequenzgenerator
12 Frequenzteiler
2 Phasenverzögerer
3 Schwingkreis
31 Schwingkreisspule
32 Schwingkreiskapazität
33 Auslöser
4 Inverter
5 Synchrondemodulator
6 Tiefpassfilter
7 Komparator
8 Verbindung
9 Schwellwertbilder

**Patentansprüche**

**1.** Targetunabhängiger Näherungssensor zur Phasenprojektionstransformation, mit einem Signalgenerator (1), einem Phasenverzögerer (2), einem Schwingkreis (3), einem Multiplikator und einem Tiefpassfilter (6), wobei der Signalgenerator (1) sowohl über den Phasenverzögerer (2) als auch über den Schwingkreis (3) mit dem Multiplikator (5) und dieser wiederum mit dem Tiefpassfilter (6) verbunden ist,
**dadurch gekennzeichnet, dass** der Signalgenerator (1) ein Rechtecksignalgenerator und der Multiplikator ein Synchrondemodulator (5) ist und ein Invertierer (4) zwischen dem Schwingkreis (3) und dem Synchrondemodulator (5) vorgesehen ist.

2. Näherungssensor nach Anspruch 1, **dadurch gekennzeichnet, dass** die Schwingkreisfrequenz ν zumindest annähernd gleich der Resonanzfrequenz des Schwingkreises (1) ist.

3. Näherungssensor nach Anspruch 1, **dadurch gekennzeichnet, dass** der Signalgenerator (1) einen Frequenzteiler (11) und der Phasenverzögerer (2) ein Schieberegister umfasst.

4. Näherungssensor nach Anspruch 1, **dadurch gekennzeichnet, dass** ein Komparator (7) mit dem Tiefpassfilter (6) und einem Schwellwertbilder (9) verbunden ist.

5. Näherungssensor nach Anspruch 4, **dadurch gekennzeichnet, dass** der Signalgenerator (1) und der Schwellwertbilder (9) an eine Speisegleichspannung U0 angeschlossen sind.

6. Verfahren zum Betrieb eines Näherungssensors mit Phasenprojektionstransformation nach einem der Ansprüche 1 bis 5, **dadurch gekennzeichnet, dass** der Signalgenerator (1) ein Rechtecksignal U1 erzeugt, welches einerseits auf den Schwingkreis (2) gegeben wird und andererseits um eine Phase ξ verschoben den Synchrondemodulator (5) ansteuert, welcher abwechslungsweise ein Schwingkreissignal U4 oder ein invertiertes Schwingkreissignal $\overline{U4}$ auf den Tiefpassfilter (6) schaltet.

7. Verfahren zum Betrieb eines Näherungssensors nach Anspruch 6, **dadurch gekennzeichnet, dass** ein Komparator (7) ein tiefpassgefiltertes Signal U6 mit einem Schwellwert U9 vergleicht und der Sensor als Näherungsschalter fungiert.

EP 1 248 369 A2

Fig. 1

Fig. 2

6